# EUROPEAN PATENT SPECIFICATION

(11) **EP 1 720 254 B1**
(45) Date of publication and mention of the grant of the patent: **27.08.2008**
(21) Application number: 06015347.5
(22) Date of filing: 12.04.2002
(51) Int. Cl.: H03K 17/955, G01R 27/26

(54) **Capacitive sensor**
Kapazitiver Sensor
Capteur capacitif

(30) Priority: 12.04.2001 GB 0109269; 12.12.2001 GB 0129765
(43) Date of publication of application: 08.11.2006
(62) Divisional of application: 02761940.2
(73) Proprietor: AB Automotive Electronics Ltd., Cardiff, CF14 7YS (GB)
(72) Inventor: Moon, Anthony, Llandaff, Cardiff, CF5 2QH (GB); Vargas, Mauricio, AB Automotive Electronics Ltd., Whitchurch, Cardiff, CF14 7YS (GB)
(74) Representative: Midgley, Jonathan Lee

(56) References cited:
- DE-A1- 4 006 119
- US-A- 1 984 166
- US-A- 3 784 905

## Description

This invention relates to an improved capacitive measuring device, particularly for use in detecting the proximity of objects and as a collision avoidance device in a vehicle.

Capacitive proximity sensors are commonly used in industrial applications for locating the presence of materials and performing endstop location. Capacitive sensors have been used for aircraft measurement to the ground at least since the 1940's. More recently capacitive sensors have been used in parts of cars for collision avoidance purposes. These sensors can suffer from a number of problems caused by environmental variations such as those caused by movement of the vehicle or variation of the properties of the surroundings. This can lead to inaccurate and unreliable information being produced. Whilst steps can be taken to mitigate these problems, the effect of water on these sensors has so far proved extremely difficult to deal with.

These sensors are designed to detect changes in a generated electrical field. Therefore, any moving object will have some effect on this field, particularly where the object is a good conductor or is close to the detector. Water falling onto and rolling off a vehicle or vehicle bumper meets both these criteria and can significantly affect the output from a sensor. This is clearly undesirable as it leads to unreliable output from the sensor.

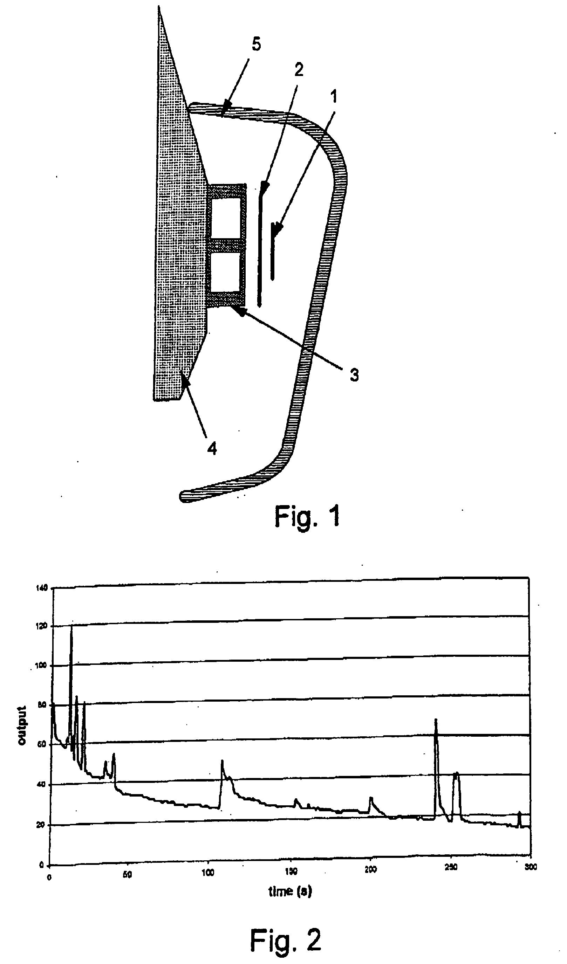

Figure 1 shows an exemplary layout of a capacitive sensor used on a vehicle to detect objects in the proximity of the front or rear of the vehicle. A typical arrangement of a bumper on a vehicle is to mount an impact beam 3 onto the body 4 of the vehicle. The bumper is then attached to the vehicle in order to cover the impact beam. The bumper is generally formed of impact absorbing material (not shown) such as foam material or a some other structure designed to absorb the energy of an impact. A skin 5 is then provided surrounding the foam or other structure. A sensor plate 1 and a guard plate 2 are typically mounted inside the bumper of a vehicle

Sensors similar to that shown in Figure 1 are known in the prior art. For example, such a sensor is described in the applicant's prior application, published as WO-A-01/08,925 which is incorporated herein by reference. A sensor typically consists of two strips of metal, or other conductive material, insulated from each other and provided inside the bumper of a vehicle. The two strips of metal form a guard plate 2 and the sensor plate 1. The plate which is outermost relative to the vehicle is called the sensor plate 1 and the plate which is innermost i.e. closest to the vehicle itself, is the called the guard plate 2. Figure 1 shows an example of the arrangement of the guard and sensor plates relative to each other.

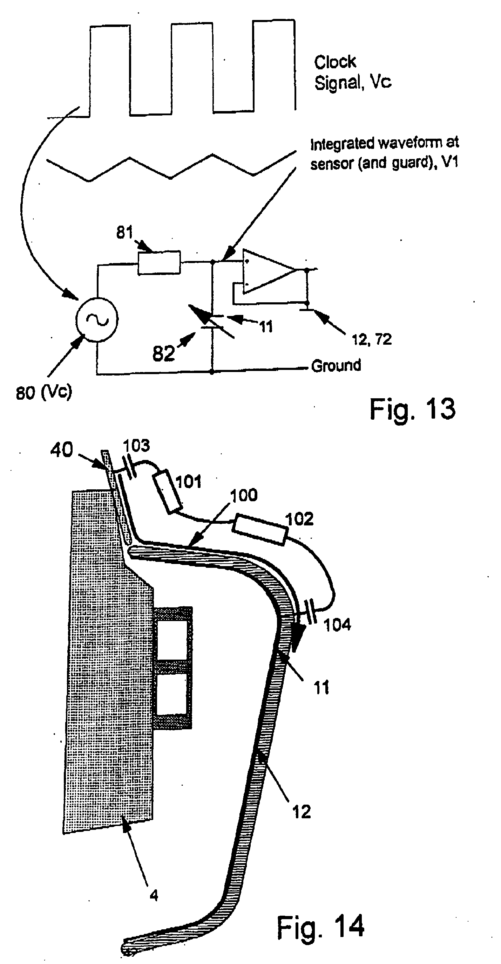

In use, the guard and sensor plates are connected to a control unit (see Figure 13). The control unit supplies high frequency signals to the sensor and guard plates. Objects in the vicinity of the vehicle present a capacitance to ground. In fact this capacitance is formed by two capacitances in series, that is: the capacitance between the sensor plate and the object (or objects) being sensed; and the capacitance between the object and ground. The control unit monitors the capacitance between the sensor plate and ground. The unit may be triggered automatically when reverse gear is engaged (for a rear mounted system), manually or otherwise. When the unit is triggered, the initial capacitance provides a reference output. As the distance between the vehicle (and hence the sensor) and an object changes, the measured capacitance changes. The output from the control unit provides an indication of the distance between any objects in the vicinity of the vehicle and the sensor plate, and hence the rear of the vehicle. The control unit senses the change in capacitance and uses this to provide an indication of the distance to the object. This indication can be provided in any number of ways. For example the control unit can be arranged to provide different tones depending on the range to a target. A broken tone could be output when the object is for example 80 cm away, then as the target moves closer, at about 50 cm the tone could become faster, and finally at a close range of about 30 cm the tone could change to a continuous tone to signal the driver to stop reversing.

As indicated above, the sensor operates by detecting objects which are generally outward of the vehicle. The guard plate acts as a shield to reduce the sensitivity of the device to anything behind the sensor plate 1. In this way, the sensor is effectively blind on the vehicle side of the sensor plate. The guard plate can be modified in a number of ways to affect the sensitivity of the sensor in various other directions such as downwards to reduce the sensitivity of the sensor to the motion of the sensor relative to the surface over which the vehicle is travelling. In this way, the sensor can be directed to detect only in those regions where there is likely to be hazard. In the case of a vehicle this is likely to be the zone immediately behind the vehicle and perhaps also in the areas around the rear corners (in a rear mounted sensor arrangement). Thus as the vehicle is manoeuvring backwards and perhaps also turning, any objects which the vehicle is likely to collide with will be sensed by the sensor and a warning can be given to avoid such a collision. However, there is a limit to how much of the detecting area of the sensor can be eliminated without adversely affecting the capabilities of the sensor. Consequently, it is impossible to completely screen out the detection of objects which may be harmless or irrelevant to the movement of the vehicle. As such, anything which is detected by the sensor which does not represent a hazard to the vehicle can lead to false indications of hazardous objects and hence false triggering of any warnings provided by the device.

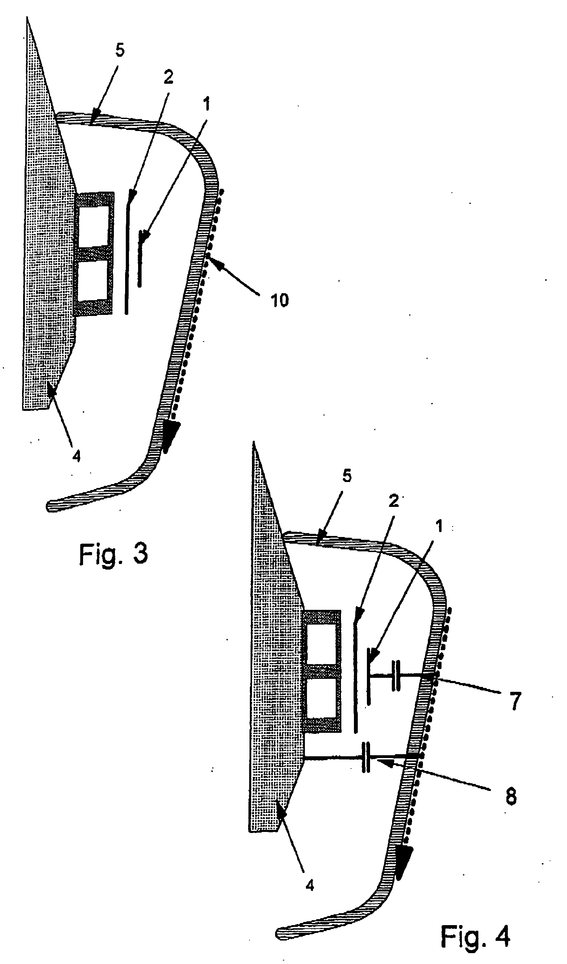

One particularly significant problem is the presence and movement of water in the detection area of the sensor. The presence of water such as that caused by steady rain tends to provide a fairly continuous effect on the sensor and can be compensated for to an extent. However, in windy weather, the rain falling on the car varies from second to second. Also, where water collects and is then released suddenly, the sensor sees a sudden change which can lead to false triggering. For example, as rain falls onto the vehicle itself, the water runs down the back of the vehicle in drips which grow in size as they collect more water. These drips may then fall onto the bumper and roll down its outer skin. A typical path 10 of such a drip is shown in Figure 3. As the drip travels past the sensor, the sensor registers it due to the change in capacitance between the sensor plate and ground. Because the drip is very close to the sensor plate 1 and also because the drip contains water which has a relatively high electrical conductivity, the effect of the drip is quite significant even though the drip itself maybe quite small. This may have an effect on the sensor similar to a much larger or more conductive object which is much further away e.g. an iron bollard behind the vehicle. In addition, the sudden change of the measured capacitance as the drip travels rapidly from the top to the bottom of the bumper may also mislead the sensor into believing that there is an larger object close to or approaching the bumper and signal a false alarm as a result.

In this description, a 'drip' is intended to refer to anything from a single small droplet, e.g. having a dimension of a few millimetres, up to a small rivulet which runs over the bumper. Such a rivulet may only be transient but may be a few centimetres long. For example, if a small pool of water has gathered somewhere higher up on the vehicle and the vehicle motion causes the pool to be displaced, the water will run down the vehicle and over the bumper briefly forming a rivulet which then flows until the displaced water is exhausted. Such rivulets are particularly problematic as they electrically connect, via their own conductivity, different regions of the sensor together. This can further exacerbate the size of a false measurement.

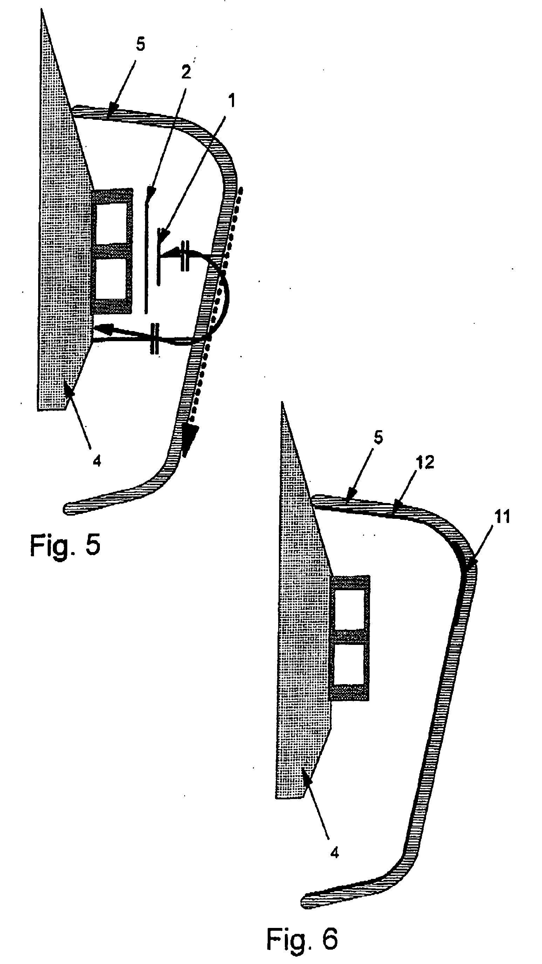

Figure 4 shows schematically how the drip affects the sensor. As the water drip falls down the outer surface of the bumper, the drip is capacitively coupled, as represented by capacitor 7, to the sensor plate 1. As the drip travels down the bumper, it then forms a capacitive coupling, shown schematically by capacitor 8 in Figure 4, with ground, in this case the car body 4. Therefore, if the drip is relatively long, a good coupling is formed between the sensor plate and ground circumventing the protective effect of the guard plate 2, as shown in Figure 5.

Figure 2 shows the results of a test to demonstrate the effects of water falling onto the bumper of a vehicle to which a capacitive sensor is attached. The arrangement of the sensor is substantially as shown in Figure 1. Figure 2 shows the output from the sensor over the course of the test period. At the start of the test, water is sprayed onto the bumper to simulate spray and rain which the bumper may encounter during normal operation. The underlying output of the sensor is a gently decaying value starting at around 70 (arbitrary units) decaying to approximately 20 after 300 seconds. However, throughout the period there are a number of spikes and elevated periods caused by the movement of water drips over the surface of the bumper. As can be seen from Figure 2, the effect of this water movement is very unpredictable both in terms of the effect on the magnitude of the output as well as the duration over which the output is effective. The sensor needs to detect progressive changes in capacitance as objects get closer to a manoeuvring vehicle. The spikes and elevated output caused by water make it very difficult to identify such small changes.

Another problem with dealing with the problems of water passing over the surface of a bumper is that the effect depends upon a number of factors which means that a solution to the problem on one bumper on one vehicle will be different to the solution for the same bumper on a different vehicle or a different bumper on the same vehicle and so on. This is because there are a large number of factors which affect the detection of the drips of water and hence the variation of the output from the sensor device. These include: the pattern that the water follows when it flows off the vehicle; the total width of the guard plate at that point; the gap between the guard and the skin of the vehicle bumper; the gap between the sensor plate and the skin of the vehicle bumper; the dielectric constant of the various materials involved; and any residual capacitive coupling between the drip and ground, principally the car body.

Therefore, in order to overcome the problems described above and reduce or eliminate the sensitivity of the sensor to harmless drips of water, there is a need improve on the detectors of the prior art.

Therefore according to the present invention there is provided a capacitive sensor unit for mounting to a body, the unit comprising: a sensor plate; a guard plate interposed, in use, between the sensor plate and the body; and a cover, wherein the guard plate is arranged adjacent to a first area of the cover and the sensor plate is arranged adjacent to a second area of the cover, the second area being partly or completely within the first area such that, in use, liquid passing over the cover passes over a part of the first area before passing over the second area.

The present invention also provides a vehicle bumper to which a sensor as described above is attached. The present invention further provides a vehicle having a sensor as described above attached thereto.

By arranging the guard plates to be in close proximity to the outer surface of the housing over which liquid (such as rain) is likely to flow, ensures that the water is screened from the grounded object to which the housing is mounted. For a vehicle application, this will be the body of the vehicle on which the bumper is mounted. Therefore, the problem demonstrated in Figure 5, namely capacitive coupling between the sensor plate and ground (in this case the car body) can be avoided by preventing the water from capacitively coupling to ground by the provision of the enlarged guard plate. The enlarged guard plate ensures drips on the bumper are screened and so their affect on the output sensor is considerably reduced.

A further way to attenuate the sensitivity of the sensor to drips of water on the outer surface of the housing is to increase the distance between the sensor plate and the surface of the housing over which the water may pass. The increase in the distance can be provided by setting the sensor plate back from the inner surface of the housing, and hence away from the surface over which the water flows. As the sensor plate is moved progressively back, the guard plate has a stronger effect on the sensor's sensitivity to drips. This tends to lead to negative spikes being generated on the output shown in Figure 2. This helps to mitigate the effect of the drips overall.

Although the sensor is generally mounted on the inside of the outer surface of the housing, the sensor can be mounted on the outer surface of the housing. In fact, the sensor may be formed by an electrically conducting coating on the outer surface of the housing which may in fact be coloured paint applied to the surface.

As indicated above, the present invention is preferably applied to a moving vehicle or object to provide a proximity sensor to provide a warning against objects coming towards the vehicle or which the vehicle is moving towards. Therefore, the sensor is preferably provided in a bumper of a vehicle, the bumper acting as the housing. In this way, the skin of the bumper forms the outer surface of the housing and the guard plate is preferably mounted on the inner surface of the bumper skin with the sensor sandwiched between the guard plate and the inner surface of the bumper skin. The sensor may be mounted within or on the outer surface of the bumper skin.

In addition to the enlarged guard plate, the problem of false triggering caused by water or other liquid passing over the surface of the bumper can be mitigated by minimising the amount of water which passes over the bumper. Typically, liquid such as rain which falls onto a vehicle will land on the bumper itself but it will also land on the rest of the vehicle. A portion of that which falls on the rest of the vehicle will run down the front and back of the vehicle and onto and over the bumpers. As a result, water falling on a significant area of the vehicle is caused to run over the bumper. Therefore, in order to further improve the attenuation of the effects of water running off the bumper, it is desirable to avoid as much water running over the bumper as possible. In order to achieve this, the present invention may further include a bumper which is arranged to divert the water running off the vehicle to flow between the bumper and the vehicle. In this way, the liquid is channelled between the vehicle body, which is effectively grounded, and the guard plate. The guard plate is positioned between the sensor and the moving liquid and shields any effect that the liquid may have on the sensor. The drips will be capacitively coupled to ground but will not be able to form a capacitive coupling with the sensor plate due to the shielding effect of the guard plate. Therefore, by diverting a significant amount of the water away from passing over the bumper, a considerable improvement in the interference caused is achieved.

As indicated above, it is desirable to avoid water coming off the vehicle body and running onto the outer surface of the bumper. This is because the water which runs off the vehicle is strongly coupled to the grounded car body, particularly if it is a long drip which might extend from a region in close contact with the car body to a region near to the sensor plate.

Similar interference problems can occur where water has run over the surface of the bumper and then runs underneath the bumper where it eventually falls off the bumper at its lowest point. This lowest point may often be very close to the body of the vehicle as can be seen from the figures. In addition, it may be undesirable to extend the guard plate to extend over the entire internal surface of the bumper. This can mean that the drip couples the sensor plate to the body of the vehicle below the bumper. Therefore, a lip is preferably provided on the outer surface of the bumper to cause liquid running over the surface to break away. This is preferably arranged to happen so that the water breaks away at a point on the outside of the body before the guard plate ends on the inside. This prevents the water running on beyond the end of the guard plate and consequently coupling capacitively with the grounded car body.

The idea of providing a lip, as described above, may be additionally developed by providing a second lip separated from the first to ensure that liquid which is running from the opposite side, i.e. from behind the bumper, is kept away from the water which has run down the front of the bumper. Water which has run down the inside of the bumper or from off the bottom of the vehicle itself will be strongly capacitively coupled with the grounded vehicle. Therefore it is desirable to avoid this water coming into contact with the water which has run down the outside of the bumper as this forms an electrical connection between the two flows of water and effectively form a capacitive couple between the sensor plate and the grounded vehicle. Therefore, the provision of a second lip ensures that the water coming from behind the bumper is caused to drop off the first lip whilst the water coming down the front of the bumper is caused to fall off the second lip and the two sources of water are prevented from coming into contact with each other.

A similar pair of lips may be provided on the upper surface of the bumper to prevent water which runs down the front on the bumper coming into contact and forming a connection to water running down the back of the bumper.

The use of lips is not limited to a vehicle bumper application. The principle is equally applicable to any application where a housing containing a sensor has water running over it and where water which may be coupled to a grounded body may come into contact with that water.

As a further modification, the sensor may be mounted outside the bumper, perhaps in a separate housing. For example, the sensor may be incorporated in a separate housing which is then attached to or inserted into a slot on the outer surface of the bumper. This allows the sensor to be manufactured independently of the bumper with the sensor being attached subsequently. This also helps to avoid any problems due the conductivity of the bumper or any coating on it, e.g. conductive paints or trim elements because the sensor will be outermost on the vehicle relative to the bumper or any coating on it.

Where the sensor is mounted in a separate housing, the problem due to water passing over the front of the sensor can still occur. This effect can be reduced in a similar way to the bumper by making the guard plate as large as possible and by minimising the gap between the sensor plate and the outer surface of the housing. Minimising the water passing over the front surface also improves the performance of the sensor. This can be achieved as described above by diverting water away from the front of the bumper and hence away from the sensor housing. However, either instead or in combination, any water which does run over the surface of the bumper can be diverted to run behind the housing, i.e. between the sensor housing and the outer surface of the bumper. Water passing this way will pass behind the guard plate and so shield the sensor plate from the effects of the water. Alternatively, the water may be carried along the housing to be released where it will not affect the sensor. Thus the water may be carried to the side of the vehicle or it may be released at points where the sensor plate sensitivity is reduced e.g. by providing a gap in the sensor which would allow water to pass by without affecting it. The water may also be carried along a part of the housing to one or more drain holes provided along its length.

The arrangement of the present invention may further comprise an additional plate which is mounted on the bumper, preferably on the inside surface, in a similar manner to the guard plate. This additional plate is preferably arranged near the top of the bumper so that liquid running off the upper part of the vehicle and onto the bumper runs over the part of the bumper adjacent to where this third plate is mounted. In this way, the capacitive coupling effect between the water and the grounded vehicle body is neutralised by providing a buffer zone which reduces the capacitive coupling effect of the liquid with the grounded body of the vehicle. The third plate is preferably provided with the same voltage signal, i.e. having the same phase and waveform, as the sensor plate, at the same or greater amplitude. This can be achieved by connecting the additional plate to the same voltage source used to provide the drive for the sensor plate. The voltage source is preferably connected to ground via a resistor and capacitor in series. The connection to the plate is provided between the resistor and the capacitor.

A specific embodiment of the present invention will now be described in detail by reference to the following drawings in which:
Figure 1 shows an example of a typical arrangement for capacitive sensor used in a vehicle bumper;
Figure 2 shows experimental data showing the affect of water on a vehicle bumper;
Figure 3 shows the path of a drip rolling over a bumper;
Figure 4 shows schematically how a drip of water capacitively couples the sensor to a vehicle body;
Figure 5 further explains the capacitive coupling of the sensor to the vehicle body;
Figure 6 shows the first embodiment of the present invention;
Figure 7 shows how the effect of liquid passing over the bumper can be reduced;
Figure 8 shows the path of the water travels over the bumper of the present invention;
Figure 9 shows an alternative modification of the bumper of the present invention;
Figure 10 shows a further modification of the bumper of the present invention;
Figure 11 shows a schematic representation of a further modification of the present invention;
Figure 12 shows further modifications of the present invention in which a third plate is provided;
Figure 13 shows the basic drive circuit waveform for driving the sensor of the present invention;
Figure 14 shows schematically the equivalent circuit caused by water passing over the bumper of the present invention without the modification shown in Figure 12;
Figure 15 shows schematically an equivalent circuit where water passes over the bumper according to the embodiment of Figure 12;
Figure 16 shows a modified circuit for use in driving the embodiments shown in Figure 12;
Figure 17 shows the equivalent circuit for the embodiment of Figure 12;
Figure 18 shows the change in output due to a series of drips passing over a reference sensor;
Figure 19 is a graph showing the effects of a drip passing over a sensor having a small guard plate;
Figure 20 shows a graph of the effect of a drip passing over a sensor plate which is spaced apart from the surface over which the drip is passing;
Figure 21 shows a graph of the effect on the output of a sensor due to a drip with a large guard plate but no gap between the sensor and the bumper skin;
Figure 22 shows a comparison between the effect on the sensor output with distance between the sensor plate and the surface of the water on which the water is flowing;
Figure 23 shows how a series of comparisons is carried out at different spacing to determine the optimum spacing to minimize the effect on the central output;
Figures 24A and 24B show two different arrangements of vehicle bumpers having spacers provided therein;
Figure 25 shows an alternative embodiment of the present invention in which the sensor plate and guard plate is provided in a trim insert; and
Figure 26 shows a detailed view of the trim insert of Figure 25.

The following description relates to the application of the sensor of the present invention to a vehicle bumper mounted on a vehicle. Therefore the sensor is principally described in the context of how to detect objects which may come close to the bumper of a vehicle, However, the sensor of the present invention may be used in other arrangements, for example where the sensor is maintained stationary but detects objects which are moving relative to the sensor. The present invention may, for example, be used as sensors on robot arms to prevent collisions with objects as the arm moves. Also, these sensors may be used as guards on machinery, for example to stop a machine when a hand is inserted into a dangerous area.

This invention is particularly applicable to environments where condensation, spray or rain may land on the sensor or sensor housing, However, in general, the present invention addresses the problem of attenuating noise caused by the passage of water over the housing of a sensor which is mounted to an object for determining its distance from other objects.

In Figure 6, a modified bumper of the present invention is shown. In this arrangement, the sensor plate 11 has been moved forward into close proximity to the inner surface of the bumper skin 5. An enlarged guard plate 12 is then laid along the interior surface of the bumper skin 5. In this way the sensor plate is sandwiched between the bumper skin and the guard plate. By providing the guard plate along substantially all of the interior surface of the bumper skin, any water which comes into contact with the bumper and then flows over it, is closely coupled to the guard plate rather than to the grounded body of the vehicle 4. The guard plate is maintained at substantially the same voltage as the sensor plate and so the effect of the water as it couples capacitively to the sensor plate is drastically reduced.

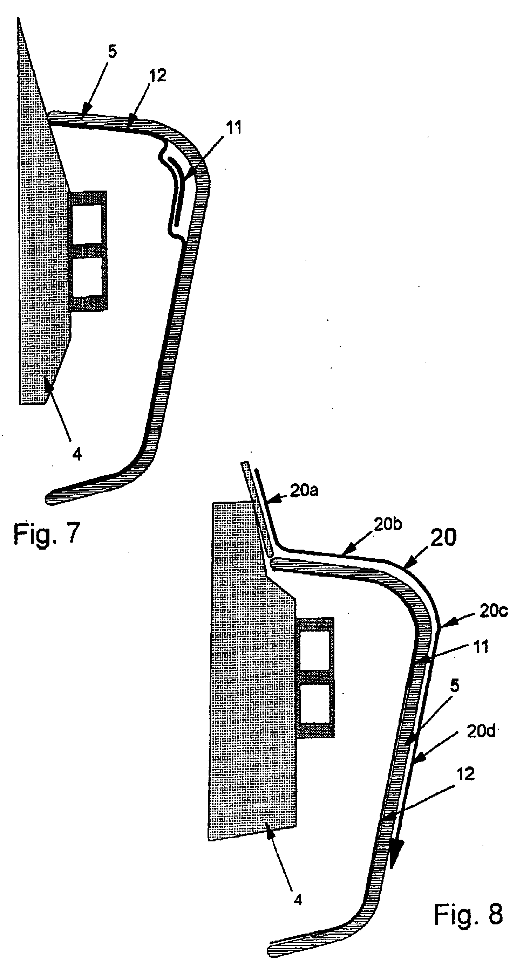

Figure 7 shows a modification of the arrangement of Figure 6 in which the guard plate includes a portion set back from the surface of the bumper skin defining a well or trench. The sensor plate sits in this well such that it is also set back from the surface of the bumper. The effect of the sensor sitting in the well defined by the guard plate is to reduce the effective aperture of the sensor. By setting the sensor plate back from the inner surface, the drips are further away from the sensor plate as they travel past and so have a smaller effect because they 'appear' to the sensor to be smaller. The effect on the output of the sensor is to produce negative spikes on the output waveform shown in Figure 2 which cancels out the positive spikes and helps to produce a balanced output which overall is less sensitive to drips.

In Figure 8, the arrangement of Figure 6 is shown with the track of a drip of water shown by the arrow 20. As the water flows from the tailgate, boot lid or other part of the car body 40, it follows the path 20a. At this point the drips are strongly coupled to the car body 4 via the tailgate, boot lid or other part of the car body 40 (referred to hereinafter as the tailgate). It is assumed that the tailgate is electrically connected or at least strongly capacitively coupled to the main body of the vehicle and is thus effectively grounded. As the drip passes from the tailgate to the top of the bumper at a position 20b, the drip begins to couple with the guard plate provided on the opposite side of the bumper side. As the drip continues along the surface of the bumper skin towards the sensor plate, the drip is more strongly coupled to the guard plate than to the tailgate 40 and the rest of the vehicle body 4, i.e. ground. Therefore, when the drip reaches the region 20c adjacent the sensor plate 11, the drip is primarily coupled to the guard plate which is maintained at the same voltage as the sensor plate (see below).

The drip continues past the sensor plate and further on down the bumper away from the sensor plate. As the drip moves away from the sensor plate, the drip remains capacitively coupled with the guard plate below the sensor plate. So again there is little or no capacitive coupling between the drip and ground and so there is little or no effect on the output of the sensor. As the drip continues on down towards the bottom of the bumper, it is so far away from the sensor plate by the time the drip runs off the bumper, where the guard plate ends, that there is little or no capacitive coupling between the sensor plate and drip and so any coupling to ground has no effect. Consequently, throughout the journey of the drip, from on the vehicle body onto the bumper and along the bumper past the sensor plate, the output from the sensor is barely affected.

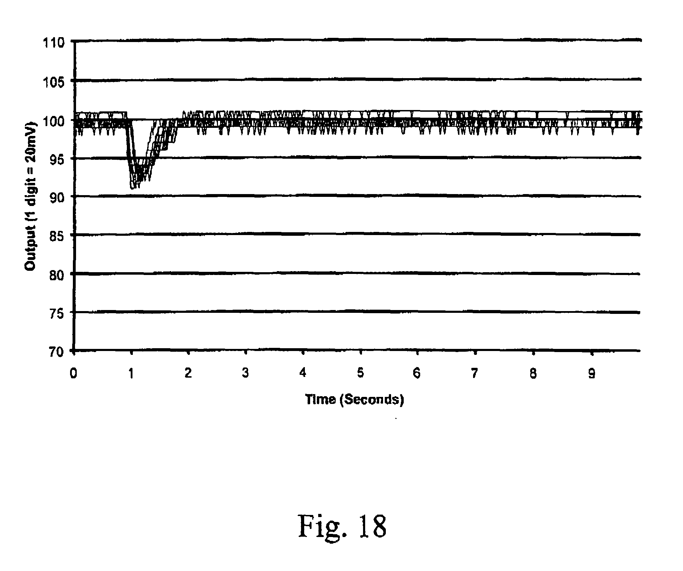

In order to minimize the effect of water passing over the surface of a bumper or other similar object, the present invention can be applied in different ways on the same object. Thus, in the example of a vehicle bumper, drips of water may have different effects on different parts of the bumper according to the surrounding structure. Experimental analysis confirms that drops passing over the same part of the bumper will always have roughly the same effect on the output of the sensor. Figure 18 shows a graph showing the results of an experiment in which a series of drips are released at timed intervals over the same part of a bumper. As can be seen, as the drip begins its path, it has virtually no effect on the sensor output until about 1 second into its journey. At this point, the drip comes into the sensing range of the sensor plate and causes the output of the sensor to drop significantly. This reduction continues for the duration that the drip passes over the area of the sensor plate. Eventually the output level returns to its original level as the drip finally clears the area in which the sensor plate senses. It will be seen from Figure 18 that the effect of each drip is substantially identical to each other drip. Specifically, the effect on the output level is substantially the same for each drip.

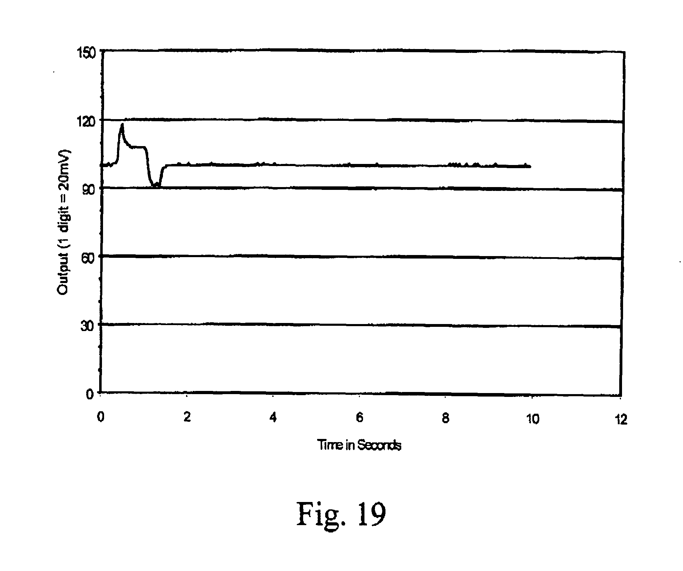

Figure 19 shows a test carried out using a guard which is small. Because the guard plate is small, the sensor plate is not protected from being coupled to ground through the drip as the drip rolls down the upper surface of the bumper. Thus, as shown in Figure 19, as the drip rolls down the bumper, it couples between the sensor plate and the grounded body of the vehicle causing a large positive spike in the output. As the drip rolls further down, its coupling to the vehicle body is reduced slightly and so the output level reduces again. As the drip comes completely within the guarded area of the detector, the output level drops again in a similar way to that shown in Figure 18 such that the output level falls below its initial level until the drip moves on, away from the sensing area of the sensor plate.

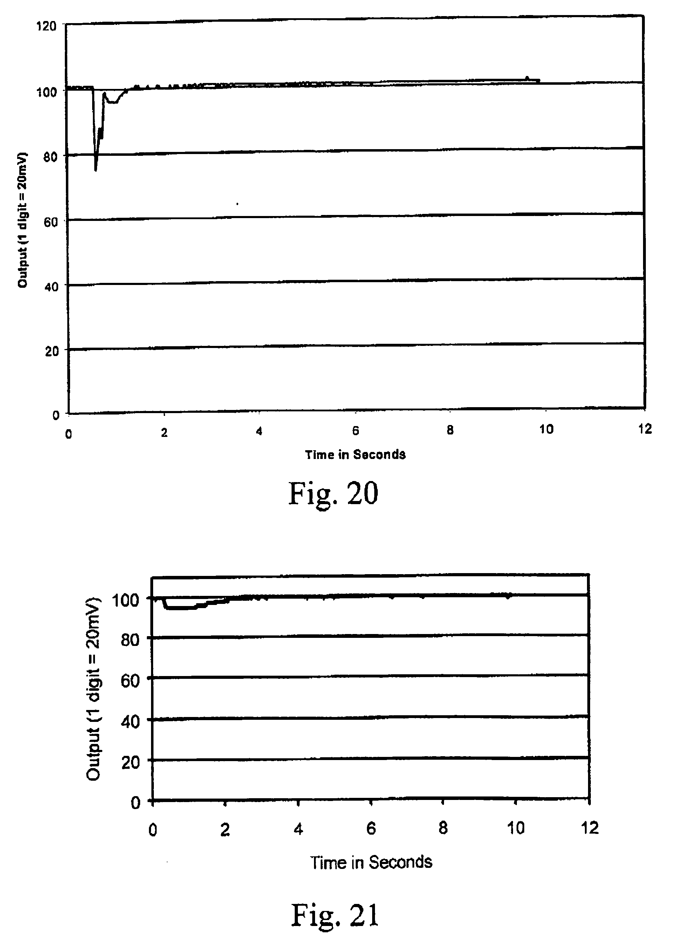

Figure 19 shows the problems associated with having an insufficiently large guard plate. The above experiment was repeated on a bumper having a larger guard plate and with a gap provided between the sensor plate and the bumper skin, i.e. the surface over which the water is passing. As can be seen from Figure 20, there is no positive spike associated with coupling between a sensor plate and the vehicle body due to an inadequate guard because of the increased size of the guard. However, the increased spacing between the sensor plate and the bumper surface causes a different effect, i.e. a large negative reduction in the output level as the drip rolls into the sensing area of the sensor plate. Therefore, the positive spike of the previous arrangement is overcome but where a gap between the sensor plate and the bumper skin is provided, a significant negative spike on the output occurs.

In the final example, the bumper is arranged with no gap between the sensor plate and the bumper skin and with a large guard plate to prevent coupling between the vehicle body and the sensor plate. This results in a profile similar to the example shown in Figure 18, with a much smaller effect on the output of the sensing device i.e. with no large positive or negative spike. Thus by selecting an appropriately sized guard and also controlling the spacing between the sensor strip and the outer surface of the bumper, these positive and negative spikes can be arranged to at least partially cancel each other out. As indicated above, the specific arrangement of the bumper chosen and its proximity to the grounded vehicle body will affect the profile of output signal for a given drip passing over the surface of the bumper. Therefore, it is preferable to optimize the gap between the sensor plate and the bumper surface and also the guard size according to the specific construction of the bumper at a given point.

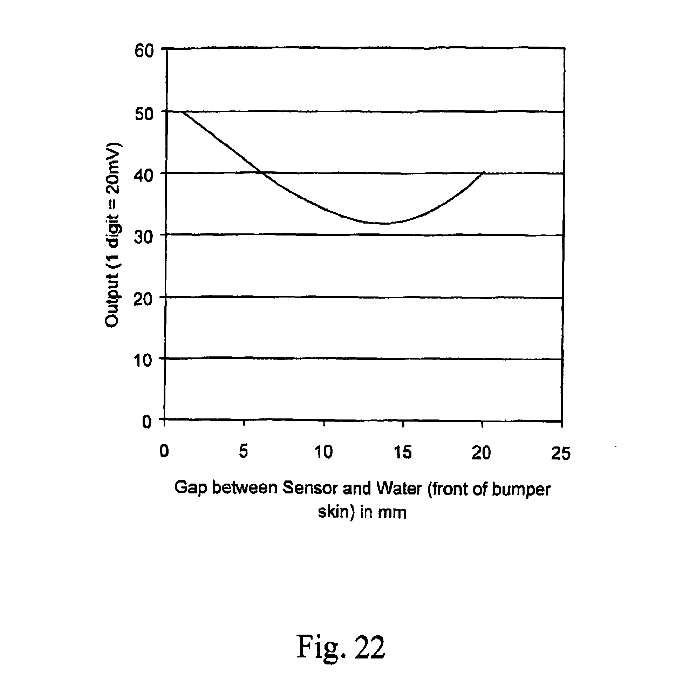

Figure 22 shows the result of an experiment carried out to determine the effect of the gap between the sensor and the bumper skin on the output of the sensor device. The graph shows the maximum deviation at the peak of the spike caused by a drip running into the sensor protection area. The results shown in Figure 22 suggest that the amplitude of the spikes caused by drips increases as the gap between the sensor and the front of the bumper skin (i.e. the drip) is increased up to about 15mm. Therefore, by adjusting the spacing between the sensor plate and the outer skin of the bumper, the effect of drips passing over the surface at a given point can be optimized to cancel out these effects and minimize the effect on the output of the sensor device.

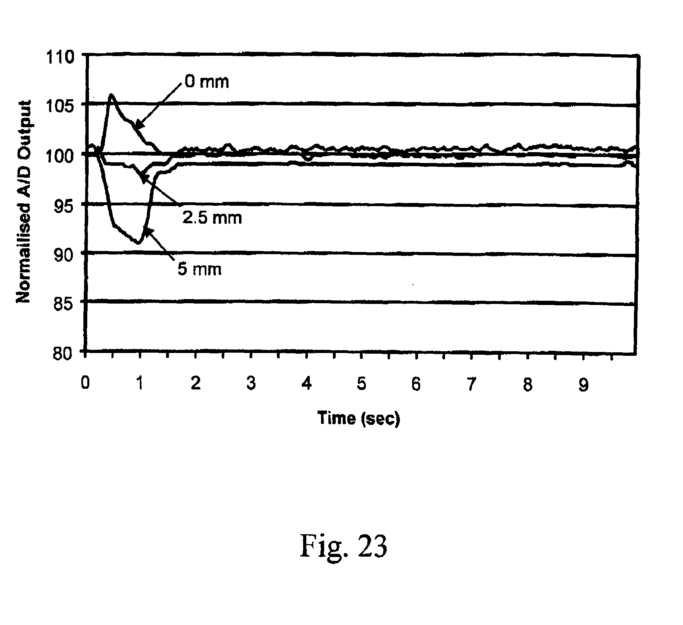

There now follows a brief description of a method of optimizing a sensing device for application to a vehicle bumper. Initially, the sensor plate is set up in a uniform arrangement with a fixed gap between the sensor plate and the outer surface of the bumper skin. The bumper is then arranged so that drips can be run over the surface of the bumper at a number of locations across the width of the bumper. Typically eight test locations would be used. At each of the eight locations, a drip is arranged to run over the surface of the bumper and the profile of the output from the sensor device is monitored. This will result in a drip profile similar to the type shown in Figures 18-21. This may be repeated with the sensor plate arranged at one or more different spacings to produce a series of profiles for each of the eight locations according to each of the selected gaps between the sensor plate and the bumper skin. A typical series of profiles is shown in Figure 23 where a test has been carried out with a gap of 0mm (i.e. no gap), 2.5mm and 5mm. As can be seen from this example, the profile shows a positive spike where there is no gap provided between the sensor plate and the bumper skin. Similarly, where a gap is too large, i.e. 5mm, a significant negative spike is shown on the output of the sensor device. However, the intermediate spacing of 2.5mm only shows a very slight deviation as the drip passes by the sensor plate. Clearly then, in this example, the optimum spacing would be 2.5mm or thereabouts.

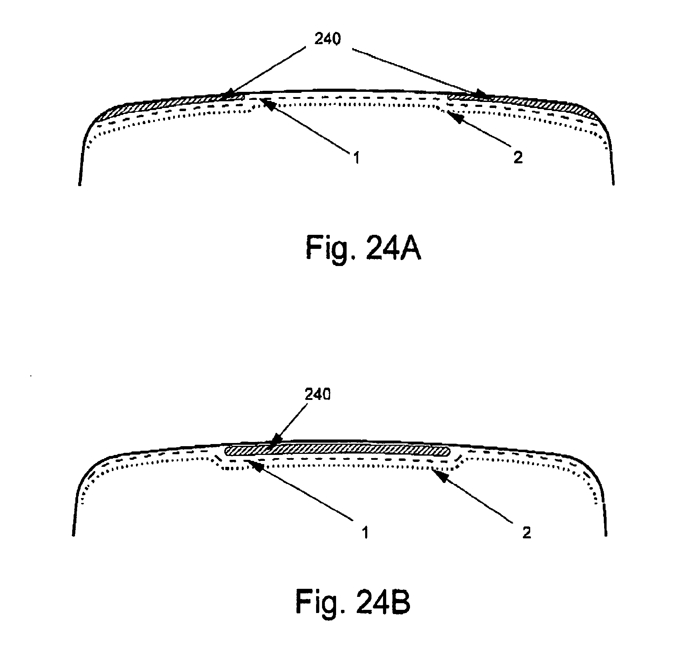

As indicated above, whilst the spacing of 2.5mm may be the optimum at one location on the bumper, this may not be the case at a different location on the bumper due to the physical arrangement of the bumper and its proximity to parts of the vehicle which are grounded. In this way, it may be that in one part of the sensor the optimum spacing is 0mm whereas at another part the optimum spacing may be 5mm. In order to provide this variation in spacing between the sensor plate and the bumper skin, spacers 240 can be provided between the bumper skin and the sensor plate to provide the necessary spacing. Figure 24A shows an overhead view of an exemplary vehicle bumper in which it is desirable to have a larger spacing between the bumper skin and the sensor plate at the edges of the vehicle but with a reduced spacing in the middle of the vehicle. To achieve this, as shown in Figure 24A, spacers 240 are provided on the outer portions of the vehicle bumper but not in the middle. Figure 23B shows a different arrangement in which it is more desirable to have a gap between the sensor plate and the bumper skin in the centre of the vehicle but not on the outer portions of the vehicle bumper. Therefore in the arrangement shown in Figure 24B, a spacer 240 is provided at the centre of the vehicle but not on the outer portions. The representation shown in Figures 24A and 24B are merely schematic but it will be appreciated that the spacers can simply be applied to the inner surface of the bumper skin at the appropriate locations and with the appropriate thicknesses so that the sensor plate can then be applied to the resulting modified inner surface of the bumper with the guard plate being applied behind that. The spacers 240 shown in Figures 24A and 24B are substantially uniform in thickness. However, these spacers may vary in width along their length according to the required profile for the sensor plate to bumper surface gap. By conducting a series of measurements (e.g. eight) across the width of the vehicle bumper, a optimum gap can be determined at each of these eight locations which may then be interpolated to determine the optimum gap at all the intermediate locations. The spacers may then be fabricated with the appropriate thicknesses along their length to ensure that the sensor plate is separated from the bumper skin by this optimum gap at all locations. The spacers may be formed separately or as an integral part of the bumper.

The above described method relates to modifying the spacing between the sensor plate and the surface of the bumper skin to achieve optimum compensation for the effect of rain drops passing over the surface of the bumper. However, as indicated above, the size of the guard plate may be modified to also provide a degree of compensation by varying the size of the guard plate across the width of the bumper. In certain instances, it may be convenient or even necessary for the width of the guard plate to vary due to the shape of the bumper. This again can be compensated for by varying the gap between the sensor plate and the bumper skin and vice versa.

Water falling directly onto the bumper and then rolling along the surface before it falls off again effectively only ever capacitively couples to the guard plate or the sensor plate. In contrast water running from the grounded vehicle body will initially be capacitively coupled to it and hence ground. Consequently, it is this water which has the biggest effect on the output from the sensor as it travels from the grounded car body onto the bumper. In addition, the vehicle provides a much larger collection area than the bumper and so a greater volume of water flows onto the bumper via the vehicle body than falls directly onto it. Therefore, in a further modification of the present invention, the arrangement of the bumper is modified such that the water which would otherwise wash off the vehicle onto and over the surface of the bumper is re-directed to flow away from the rear of the bumper particularly where the sensor is positioned. The simplest way to achieve this is to direct the water behind the bumper although it could instead be carried to the sides of the vehicle or channelled away in some other way.

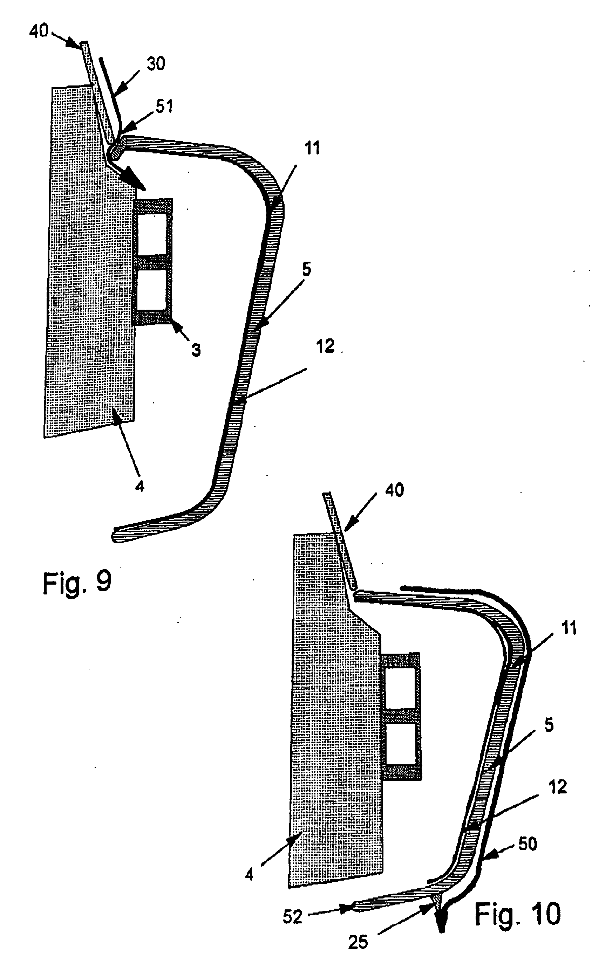

In the example shown in Figure 9, the upper part of the bumper skin 5 is set away from the vehicle with a deflecting lip 51 arranged to cause water which falls from the tailgate 40 of the vehicle body to be directed away from the outer surface of the bumper skin. Water falling from the tailgate falls onto the lip below the high point of the bumper and so has to flow down between the body of the vehicle and the rear part of the bumper. In this way, water flowing from the tailgate 40 passes between the bumper and the vehicle body.

The passage of the water in this region along the path 30 as shown in Figure 9, does not affect the sensor because the sensor plate 11 is shielded by the guard plate 12. The purpose of the guard plate 12 is essentially to shield the sensor plate from the grounded vehicle body. Therefore the movement of drips of water between the guard plate and the vehicle body will necessarily have little or no affect on the sensor. Therefore, this water will not affect the output of the sensor. In Figure 9, the path of the water 30 brings it down between the vehicle and the internal surface of the bumper. However, for practical reasons, it may be preferable to avoid the water passing over the metalwork supporting the bumper such as the impact beam 3. However, the beneficial effect of this modification can still be achieved by channelling the water away from the outer surface of the bumper in some other way for example by directing it to the sides of the vehicle by providing channels which run towards the sides of the vehicle. The important aspect of this modification is that the water does not pass over the outer surface of the bumper skin such that it passes across the "field of vision" of the sensor plate. The field of vision of the sensor plate effectively extends from the sensor plate outward away from the guard plate.

The water can be prevented from passing over the surface of the bumper in other ways. The tailgate may simply extend below the top of the bumper or the bumper may be set away from the tailgate defining a gap into which the water will pass. In a further alternative, the upper part of the bumper may be provided with a lip such that any water which does fall onto the bumper naturally flows away from the lip and behind the bumper. Again the water may be carried through the bumper itself possibly even through channels close to the surface. This would still be acceptable as long as the water was flowing on the opposite side of the guard plate to the sensor plate.

The constructions shown in Figures 6-9 all include guard plates which extend substantially over the entire interior surface of the bumper skin. Whilst, in the absence of problems due to water passing over the bumper, it is advantageous to have a guard plate which is larger than the sensor plate, it is more expensive and harder to produce a bumper which has a guard plate over its entire inner surface. The provision of the part of the guard plate over the lower half of the bumper is principally to shield the lower part of the bumper against water, which has flowed over the top of the bumper and then runs off the bottom, from coupling to the vehicle body near the bottom of the bumper. It is therefore advantageous if some or all of this lower part of the guard plate can be omitted.

Therefore, in the construction of Figure 10, a lip 25 is provided near the bottom of the bumper and projecting away from the surface of the bumper skin. The lip 25 ensures that water flows down the outer surface of the bumper it reaches the lip and cannot flow past it. The water must then flow down the lip to the bottom and then drop off, as shown by the path 50. This prevents the liquid continuing on down the lower part of the bumper skin 5 and eventually falling off the bumper at the lowest point 52. As can be seen in Figure 10, at this lowest point 52, the drip will be in close proximity to the vehicle body 4 and so would be strongly capacitively coupled to it. In Figure 8 the bumper is extended lower down to increase the physical distance between the water drip and the vehicle body. However, this can be impractical in a vehicle. Thus by providing a lip, the guard plate need only be provided between the vehicle body and the lowest point which the drip reaches before being displaced by the lip. In this construction, the water never runs down to the end 52 of the bumper and so the end of the bumper 52 can be arranged more closely to the vehicle body without significantly affecting the performance of the sensor. It will be appreciated that the lip can have any number of different configurations to provide the beneficial effect of causing water to detach from the bumper.

It will be apparent from the foregoing discussion, that the performance of the sensor can be considerably improved by avoiding water which has been in contact with the vehicle body passing near or in front of the sensor plate. However, it is also undesirable for water which has been in contact with the vehicle body and is capacitively coupled thereto to come into contact with water which runs past the sensor even if such water itself would not adversely affect the sensor due to the shielding by the guard plate. Where these two flows of water come into contact, for example at the top and bottom of the bumper, the electrical conductivity of the water provides a connection between the two flows such that, in effect, the sensor plate 11 is capacitively coupled to ground. To avoid this, an arrangement similar to Figure 10 can be used in which a lip is provided to ensure that the shielded flows of water, such as that on the outer side of the bumper, fall off at a predetermined point. However, unshielded water, i.e. that which is capacitively coupled or directly connected to the grounded vehicle, can still come into contact with the shielded water, for example at the tip of the lip where the two flows converge.

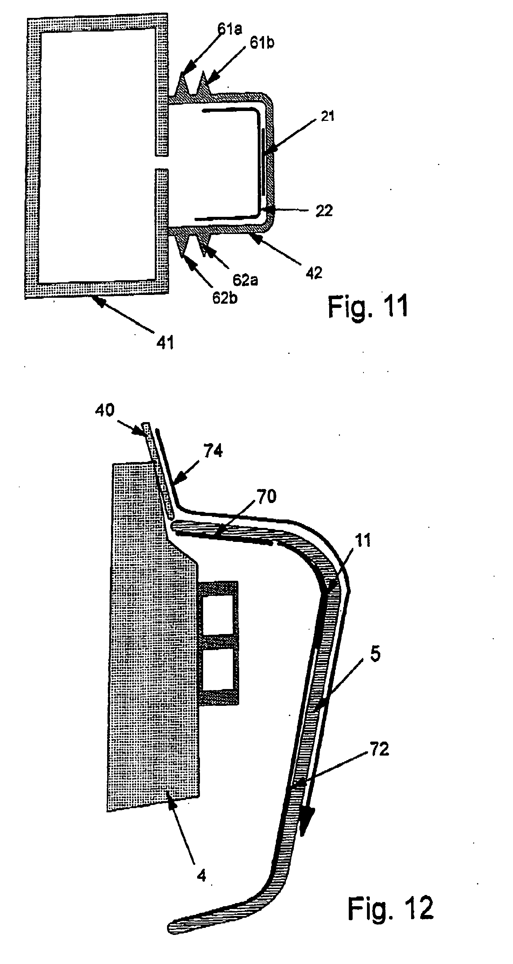

Figure 11 shows a generic sensor which has a similar arrangement to the bumper mounted sensors described above but could be used for different non vehicle applications. The sensor similarly comprises a sensor plate 21 and a guard plate 22 mounted on the inner surface of a housing 42 which is made from a non-conducting material, The housing is then mounted on a grounded conducting case 41. In order to provide separation between water which has been in contact with the grounded case (e.g. car body) and water which passes over the front of the sensor, and is thus capacitively coupled to the sensor plate 21, pairs of lips 61 and 62 are provided. In this way water which flows from the case 41 or the inner side of the housing flows onto the lip 62b whereas water which has flowed over the outer surface of the housing 42 flows onto and off the lip 62a. In a similar way, the mixing of water flowing off the top the housing over the outer side is prevented from mixing with water flowing towards the case (or down the inner side of the housing) by providing the upper pair of lips 61.

As described above, the main problem with water affecting the output of the sensor is where the water has flowed off a part of the grounded vehicle body. This can be reduced by avoiding the water flowing from the tailgate and over the surface of the bumper as shown in the construction of Figure 9. However, it may not be practical to divert the water flow away from the bumper. Therefore, in order to further reduce the effect of water flowing onto the bumper from the tailgate 40 of the vehicle there is provided the construction shown in Figure 12. In this arrangement, the guard plate 72 does not extend to the very top of the bumper leaving an area at the top of the bumper in which a third or drip guard plate 70 is provided.

This drip guard plate is similar to the guard and sensor plates in that it is an electrically conducting plate which is preferably attached to the inner surface of the bumper skin. The plate carries a waveform having the same shape, phase and frequency as that on the sensor plate. The amplitude of the applied voltage is the same as or preferably greater than that applied to the sensor plate. A drip rolling off the tailgate 40 follows the path 74, as shown in Figure 12.

This arrangement will now be described by considering a large drip flowing from the tailgate and over the bumper. As the drip rolls from the tailgate to the upper part of the bumper skin 5, the drip is capacitively coupled to ground. However, as the drip continues over the part of the bumper where the drip guard plate 70 is provided, the voltage on the drip guard plate couples capacitively onto the drip at one end whilst the other end is still capacitively coupled to the body panel. As the drip continues on, it comes down the bumper to the region adjacent to where the sensor plate is provided. If the drip is long enough, the sensor then couples to the leading edge of the drip with the other end still capacitively coupled to the grounded tailgate. The middle part of the drip is still capacitively coupled to the drip guard plate 70. This has the effect of coupling a voltage in phase with that of the sensor into the middle of the drip and thereby minimising any current flowing from the sensor to ground via the drip.

Figure 12 shows the drip guard plate positioned above the sensor plate such that water flows past the drip guard plate first and then passes by the sensor plate. However, the drip guard plate could be positioned below the sensor plate such that water flowing over the bumper passes the sensor plate first and then the drip guard plate. This has a similar effect in that coupling of the lower part of a drip with ground or the vehicle body is prevented by the drip guard plate. Furthermore, drip guard plates could be provided above or below the sensor plate as required, for example depending on the shape and layout of the bumper.

The operation of the sensor will now be described in more detail with reference to Figure 13. Figure 13 shows the basic drive circuit for operating the sensor of the present invention. This comprises a voltage source 80 which produces an oscillating voltage signal, in this case a square wave clock signal. This is fed via a high value resistor 81 to the sensor plate 11 which forms a variable capacitance 82 to ground via any objects in the vicinity of the sensor plate. The voltage on the sensor plate 11 is also fed to a unit gain amplifier, the output of which is connected to the guard plate 12, 72. As shown in Figure 13, the capacitor 82 formed by the sensor plate to ground forms an RC circuit with the high value resistor 81. This produces an integrated version of the clock signal generated by the voltage source 80 on the sensor plate. This waveform is shown in Figure 13. As objects move towards or away from the sensor plate, the value of the capacitor 82 formed between the sensor plate 11 and ground varies and the amplitude of the integrated waveform fed to the unity gain amplifier varies accordingly.

By connecting the guard plate to the output of the amplifier, it has the same voltage as the sensor plate without being affected by objects moving in its vicinity. In addition the sensor plate is effectively blinded by the guard plate because it is always at the same potential as the sensor plate and so anything behind the guard plate cannot be "seen" by the sensor plate 11 and so does not affect the output of the sensor. This is why the guard plate is arranged between the grounded car body and the sensor plate such that the potentially very strong capacitive coupling between the sensor plate and the grounded car body does not affect the sensor output.

Figure 14 shows how a large drip 100 forms an electric circuit between the sensor plate and the grounded body of the tailgate 40. The upper end of the drip 100 forms a capacitive coupling to the grounded body presented by capacitor 103. By considering the electrical resistance of the drip in two parts as resistor 101 and 102, representing the upper and lower parts of the drip, an electrical connection is formed to the sensor plate via the capacitive coupling between the lower end of the drip and the sensor plate as represented by capacitor 104. The result is an RC connection to ground.

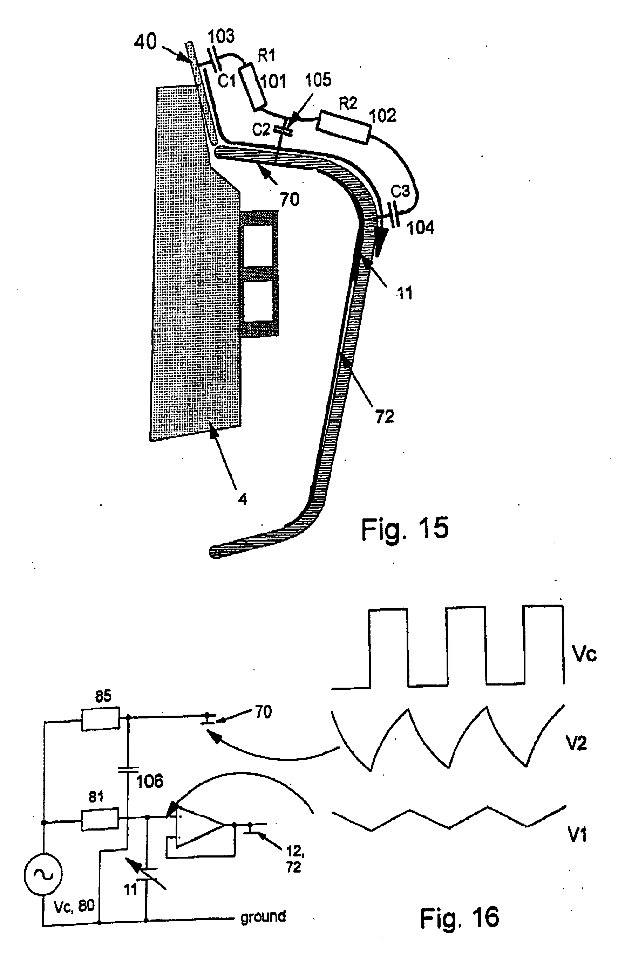

As indicated above, to counter this problem, the drip guard plate 70 as shown in Figure 12 is added. This is connected as shown in the modified circuit of Figure 16. The modified circuit includes series RC circuit between the voltage source and ground. The connection between the high value resistor 85 and the capacitor 106 is connected to the drip guard plate 70. The RC circuit generates a voltage on the drip guard plate which is the same waveform (an integrated version of the voltage source) as that on the sensor plate. The amplitude of the voltage V₂ on the drip guard plate 70 can be adjusted by varying the values of the resistor 85 and the capacitor 106. As indicated above this is preferably selected so that the amplitude of the voltage, V₂ on the drip guard plate 70 is greater than the voltage V₁ on the sensor plate 11.

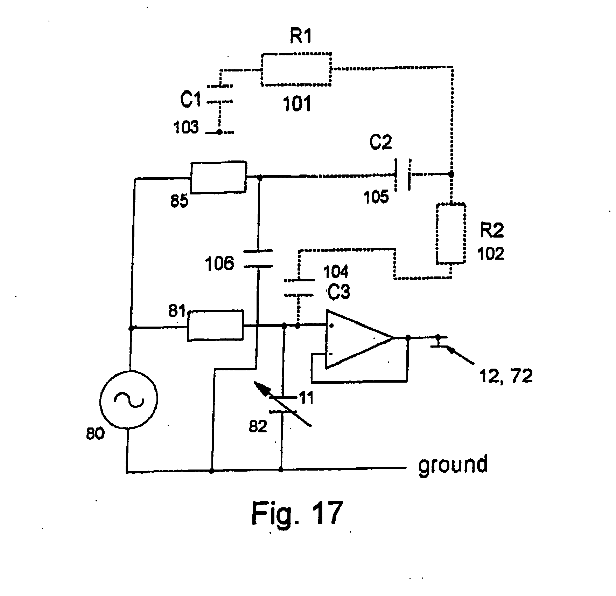

Introducing the drip guard plate 70 provides a further capacitive coupling to the region between the resistors 101 and 102 and the drip guard plate 70. This is represented by the capacitor 105 in Figure 15. If the equivalent circuit of the drip is combined with the drive circuit shown at Figure 16, the resultant equivalent circuit is shown in Figure 17. As indicated above, the capacitance 105 couples the voltage V₂ to the drip between the two resistance halves 101 and 102 of the drip. With the upper half of the drip being capacitively coupled to ground and the lower half of the drip being capacitively coupled to the sensor plate, the drip guard plate has the effect of making the signal at the sensor plate increase in amplitude. In contrast, the effect of the resistances 101 and 102 and the capacitances 103 and 104 is to make the amplitude of the sensor decrease. Thus the effect of the drip being coupled to ground can be cancelled out by selecting the correct contribution by the drip guard plate. Therefore, by carefully adjusting the size of the plate 70 and the amplitude of the signal on the drip guard plate, the effect which the drips have on the voltage at the sensor plate can be minimised to ensure they have the least effects on the output of the sensor.

Vehicle bumpers are often painted and the paints or coatings used may be conductive to some extent. The provision of such coatings can reduce the sensitivity of the sensor if the sensor is inside the bumper and hence between the vehicle and the coating. To mitigate this effect, the sensor can be mounted on the bumper outside of the conductive coating or in an area which is not painted such as a window in the coating. Furthermore, the sensor may be mounted on a special mounting such as a piece of trim which positions the sensor out from the conductive surface. The presence of such a conductive surface does not significantly affect the guard and so the guard can be positioned inside the bumper.

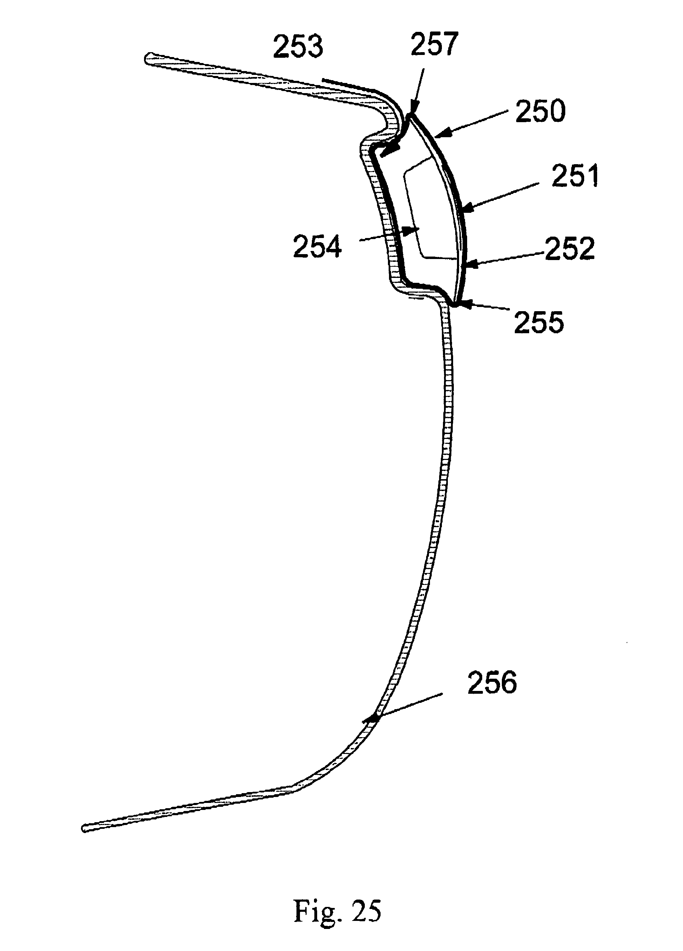

In addition, as indicated above, because every arrangement of bumper and vehicle behaves slightly differently to every other arrangement, it can be difficult and costly to try to produce a separate sensor device for each bumper and each vehicle. Therefore the present invention may be applied to a generic housing, such as a trim strip, which can be applied to the outer surface of more than one bumper. This helps to avoid any effects of the use of conductive paints or primers on the bumper surface as the entire sensor is effectively mounted outside of such a conductive surface. However, even with such a trim arrangement, it is preferable to avoid water passing over the outer surface of the sensor. Therefore by using a trim strip, it can be conveniently arranged so that the trim strip includes an upper portion which is proud of the bumper surface which deflects the water rolling off the upper part of the bumper away from the front surface of the trim strip. Figure 25 shows a schematic example of such an arrangement. A bumper skin 256 shows the outline of the bumper of the vehicle to which the sensor is mounted. This bumper skin may or may not be provided with the conductive primer or paint layer. However, as shown in Figure 25, the trim insert 250 is fitted onto the bumper skin on the outside of the outer surface of the bumper skin such that any conductive coating on the bumper skin is inward of the sensor. As before, the trim insert is provided with a sensor plate 251 and a guard plate 252. The guard plate which is effectively positioned between the sensor and the conductive coating on the bumper skin to shield any affect that the conductive skin, particularly if grounded, may have on the sensor plate. The arrow 253 shows one arrangement for deflecting the water rolling down the upper surface of the bumper skin away from the front surface of the trim insert 250. The trim insert 250 is provided with a lip 257 which is proud of the surface of the bumper skin. This defines a gap into which any water flowing over the upper surface of the bumper skin 256 can pass so that it flows away from the front surface of the trim insert. The water may be directed either to the sides of the vehicle, down behind the trim insert but still outside of the bumper skin emerging again to continue running down the outer surface of the bumper skin below the trim insert. Alternatively, the water may be directed through channels or the like to within the bumper skin and then carried away as appropriate for the arrangement of the bumper. Regardless of the route which the water takes, the important aspect is that the water is diverted from flowing over the front surface of the trim insert. Therefore, the only water which should land on the sensor and therefore run pass the sensor plate is that which actually falls on the outer surface of the trim insert itself. However, as the guard plate in 252 is arranged to extend along substantially the full height of the trim insert, any such drip would upon landing on the insert be immediately coupled to the guard plate. This coupling would minimize any affect that such a drip would have on the sensor plate and thus the output of the sensing device.

As indicated above in respect of the diversion of water from running over the bumper skin, the drips can affect the sensor both as they run onto the detecting region of the sensor plate from above as well as when they run away from the detecting region of the sensor plate and continue below the sensor. Therefore, if the water which does fall onto the front surface of the trim insert 250 was allowed to run down its outer surface past the sensor plate 251 and then run off the bottom of the trim insert onto the bumper then there could be strong coupling between the drip and the bumper surface (particularly if the bumper surface had a conductive coating on it). If the drip was close to the sensor plate, this would have a significant effect on the output of the sensor device. Therefore, in this construction a lip 255 is provided on the bottom of the trim insert 250. Such a lip should be proud of the surface of the bumper so that water flowing down the outside of the trim insert 250 falls off the lip and away from the vehicle bumper so that any coupling between the drip and the bumper is minimized. This arrangement also avoids the water running off the outer surface of the trim insert coming into contact with water which has run over the surface of the bumper (perhaps diverted from above the trim strip and re-emerging below the trim strip) which would be strongly coupled to the bumper and ground, particularly if the bumper has a conductive coating.

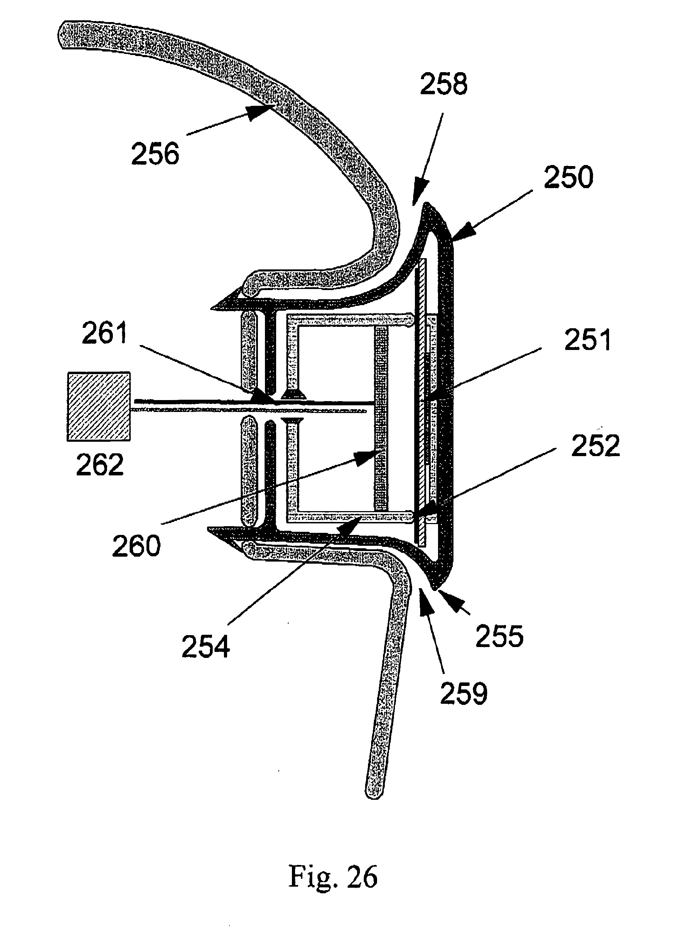

Figure 26 shows a more detailed example of a trim insert 250 which is that shown in Figure 25. Again the trim insert 250 is shown in cross-section attached to the rear surface of a vehicle bumper skin 256. In this example, the water running off the upper surface of the bumper skin 256 flows into the gap 258 provided between the bumper skin and lip 257 on the trim insert. This water is arranged to flow down between the trim insert and the bumper skin and emerge again through the gap 259 provided between the lower lip 255 of the trim insert and the bumper skin. Water then flows down away from the trim insert well out of the way of the sensor plate. Figure 26 also shows schematically how the trim insert may be constructed. A circuit board 260 would be provided within an enclosure 254 held within the body of the trim insert 250. The guard and sensor plate would be arranged to lie at the front of the trim insert connected to the circuit board. The enclosure would be provided with a sealed cable outlet 261 to which the cables to the controller for the sensor would be connected. These cables can be terminated in a connector 262. The trim insert 250 is provided with a connection means comprising engaging hooks 263 shown in Figure 26, allowing the trim insert to be simply pushed fitted into the bumper skin and to be retained there in the appropriate position defining the gaps through which the water flowing off the bumper can pass. Of course other attachment arrangements could be used such as an interference fit, fasteners, adhesive etc. The connector 262 passing out of the enclosure 254 can then simply be connected to the corresponding connector passing out from the vehicle body.

This arrangement provides an extremely convenient arrangement for the sensor which can be easily fitted to almost any bumper without extensive modification or without constraining the design of the bumper to accommodate the sensor and guard plate etc. This arrangement almost means that the sensor is easily replaced if it becomes damaged, e.g. during an impact.

Whilst a purpose of the present invention is to mitigate the effect of drips running over the surface of the housing in which a sensor is provided, it is difficult to completely eliminate the effect of drips of water entirely because of the variety of parameters e.g. size, conductivity etc. that the drips may have. Consequently there will almost always be some effect on the output of the sensor caused by drips of water running over the bumper,

A further function of the present invention can be provided by disabling or reversing the effect or the systems described above. Where a drip guard plate is being used, if it is disabled or if part of the guard plate is disconnected then the effect of water can be reintroduced. Alternatively an additional plate could be used which is normally unconnected or connected to the drip guard or guard plates, which is then grounded to disable the system. This might be achieved by a strip provided very close to the sensor plate to provide strong coupling of the sensor plate to ground.

By doing this, the effect of the water on the sensor can be utilised to provide an indication that there is water on the bumper. This can be detected either by measuring an increasing capacitance between the sensor plate and ground or an increase in noise on the sensor output. In this way, the sensor can have a secondary purpose of detecting water on the bumper to provide an indication that a vehicle is passing through spray or rain. This information can then be used when the system is not being used for proximity sensing to provide a rainfall detector to automatically operate windscreen wipers or vehicle lights and so on.

## Claims

1. A method of optimising the configuration of a capacitive sensor having a sensor plate and provided in a housing, the method comprising at one or more locations along the length of the capacitive sensor:-
conducting a plurality of tests to determine the effect of liquid passing over the surface of the housing, each test being conducted at a different spacing between the sensor plate and the outer surface of the housing;
comparing the effect on the output of the sensor at each of the different spacings between the sensor plate and the outer surface of the housing; and
determining an optimum spacing based upon the comparison.

2. A method according to claim 1 wherein the optimum spacing is determined as the spacing at which there is the least effect on the sensor output.

3. A method according to claim 1 wherein the optimum spacing is determined to lie between the two spacings at which there is the least effect on the sensor output.

4. A method according to any one of claims 1 to 3, further comprising:
constructing a spacer for positioning between the sensor unit and the housing, the spacer being constructed to have a thickness corresponding to the optimum spacing.

5. A method according to claim 4 wherein the spacer is constructed to extend between two or more of said locations such that the thickness varies to correspond to the determined optimum thickness at each location.

## Patentansprüche

1. Verfahren zum Optimieren der Konfiguration eines kapazitiven Sensors, der eine Sensor-Platte aufweist und in einem Gehäuse vorgesehen ist, wobei das Verfahren an einer oder mehreren Stellen entlang der Länge des kapazitiven Sensors Folgendes umfasst:
Durchführen einer Anzahl von Tests zur Feststellung der Wirkung einer Flüssigkeit, die über die Oberfläche des Gehäuses läuft, wobei jeder Test bei einem unterschiedlichen Abstand zwischen der Sensor-Platte und der Außenoberfläche des Gehäuses ausgeführt wird;
Vergleichen der Wirkung auf den Ausgang des Sensors bei jedem der unterschiedlichen Abstände zwischen der Sensor-Platte und der Außenoberfläche des Gehäuses; und
Bestimmen eines optimalen Abstandes auf der Grundlage des Vergleichs.

2. Verfahren nach Anspruch 1, bei dem der optimale Abstand als der Abstand bestimmt wird, an dem sich die geringste Wirkung auf das Sensor-Ausgangssignal ergibt.

3. Verfahren nach Anspruch 1, bei dem der optimale Abstand so bestimmt ist, dass er zwischen zwei Abständen liegt, an denen sich die geringste Wirkung auf das Sensor-Ausgangssignal ergibt.

4. Verfahren nach einem der Ansprüche 1-3, das weiterhin Folgendes umfasst:
Konstruieren eines Abstandsstückes zur Positionierung zwischen der Sensor-Einheit und dem Gehäuse, wobei das Abstandsstück so konstruiert ist, dass es eine Dicke aufweist, die dem optimalen Abstand entspricht.

5. Verfahren nach Anspruch 4, bei dem das Abstandsstück so konstruiert ist, dass es sich zwischen zwei oder mehreren der Stellen derart erstreckt, dass sich die Dicke ändert, um der festgestellten optimalen Dicke an jeder Stelle zu entsprechen.

## Revendications

1. Procédé destiné à optimiser la configuration d'un capteur capacitif comprenant une plaque de capteur et logé à l'intérieur d'un logement, le procédé comprenant en un ou plusieurs endroits sur la longueur du capteur capacitif, la réalisation d'étapes consistant à :
réaliser une pluralité de tests dans le but de déterminer l'effet d'un liquide passant sur la surface du logement, chaque test étant réalisé à un écartement différent entre la plaque de capteur et la surface extérieure du boîtier ;
comparer l'effet sur la sortie du capteur à chacun des écartements différents entre la plaque de capteur et la surface extérieure du logement; et
déterminer un écartement optimum en se basant sur la comparaison.

2. Procédé selon la revendication 1, dans lequel l'écartement optimum est déterminé comme l'écartement auquel l'effet sur la sortie du capteur est le moins important.

3. Procédé selon la revendication 1, dans lequel l'écartement optimum est déterminé comme se situant entre les deux écartements auxquels l'effet sur la sortie du capteur est le moins important.

4. Procédé selon l'une quelconque des revendications 1 à 3, comprenant en outre l'étape consistant à :
construire une entretoise pour un positionnement entre le module capteur et le logement, l'entretoise étant construite de façon à avoir une épaisseur qui correspond à l'écartement optimum.

5. Procédé selon la revendication 4, dans lequel l'entretoise est construite de façon à s'étendre entre deux ou plusieurs desdits endroits, de sorte que l'épaisseur varie de façon à correspondre à l'épaisseur optimum déterminée à chaque endroit.
